# EUROPEAN PATENT APPLICATION

(11) **EP 4 712 706 A1**
(43) Date of publication of application: **18.03.2026**
(21) Application number: 25782903.6
(22) Date of filing: 31.03.2025
(51) Int. Cl.: H05K 1/02

(54) **STRETCHABLE SUBSTRATE HAVING SELF-STIFFNESS DISTRIBUTION, MANUFACTURING METHOD THEREFOR, AND STIFFNESS DISTRIBUTION VARYING METHOD THEREFOR**

(30) Priority: 02.04.2024 KR 20240044607; 15.10.2024 KR 20240140705
(71) Applicant: Korea Institute of Machinery & Materials, Daejeon 34103 (KR); POSTECH Research and Business Development Foundation, Pohang-si, Gyeongsangbuk-do 37673 (KR)
(72) Inventor: LIM, Mikyung, Daejeon 34127 (KR); KIM, Hyeon-Don, Daejeon 34825 (KR); KWEUN, Minwoo, Daejeon 34080 (KR); KIM, Jae-Hyun, Daejeon 34140 (KR); KIM, Younsoo, Pohang-si Gyeongsangbuk-do 37673 (KR); KU, Kanghee, Ulju-gun Ulsan 44919 (KR)
(74) Representative: Lewis Silkin LLP
(86) International application number: PCT/KR2025/004179
(87) International publication number: WO 2025/211681

(57) **Abstract**

A stretchable substrate having a self-controlled stiffness distribution includes a stiffness-maintaining region and a stiffness-variable region that are partitioned into different areas. The stretchable substrate includes a configuration in which the stiffness-maintaining region and the stiffness-variable region maintain a predetermined stiffness only at a temperature equal to or lower than a predetermined temperature. The stiffness-variable region includes a structure in which, only at a temperature equal to or higher than the predetermined temperature, its stiffness becomes lower than the predetermined stiffness and the stiffness-variable region may deform so as to become stretchable.

## Description

### BACKGROUND OF THE INVENTION

### TECHNICAL FIELD

The present invention relates to a stretchable substrate having a self-regulated stiffness distribution, a method for manufacturing the same, and a method for varying a stiffness distribution thereof. More specifically, the present invention relates to a stretchable substrate having a self-regulated stiffness distribution, in which, as temperature varies, stiffness decreases and elongation becomes possible in a specific region, while stiffness is maintained and deformation is minimized in another region, thereby enabling region-selective elongation, and a structurally stable overall configuration is maintained and simple control of a specific factor, a simplified manufacturing process, and a simplified circuit wiring structure are performed.

### DISCUSSION OF THE RELATED ART

Various flexible electronic devices have increasingly been required, and manufacturing technologies for flexible display devices have been developed accordingly. In addition to providing simple flexibility, technologies for manufacturing stretchable display devices have also been developed.

Korean Patent No. 10-2340855 discloses a stretchable display device configured to include a stretchable substrate and a variable portion.

However, in such stretchable or flexible display devices, when the entire substrate is stretched, a device mounted on the substrate may be damaged due to its lower stretchability or may be detached from the substrate due to an increase in stiffness.

To address this issue, Korean Patent No. 10-1756847 discloses a technology in which a region on which a device is mounted is formed of a material having a relatively high elastic modulus, while another region is formed of a material having a relatively low elastic modulus.

Nevertheless, when a substrate is manufactured using such different materials, it is difficult to maintain structural stability at boundary portions between the materials, and the manufacturing process becomes complicated.

Meanwhile, Korean Patent No. 10-2368540 discloses a technique of locally changing stiffness by altering local dimensions or shapes, in addition to varying the elastic modulus. However, to implement such structural local stiffness variation, additional manufacturing processes are required, and wiring becomes complicated.

Accordingly, there is an increasing technical demand for a stretchable substrate that may maintain relatively high stiffness in a region where a device is mounted, while providing structural stability at boundary portions, and that may achieve control of parameters such as Poisson's ratio and anisotropic elastic modulus, while including a simple manufacturing process and simple wiring. In particular, a stretchable substrate having a self-regulated stiffness distribution is increasingly required.

### SUMMARY

Accordingly, the technical task of the invention is derived from these points, and exemplary embodiments of the present invention provide a stretchable substrate having a self-regulated stiffness distribution capable of achieving region-selective stretching by allowing a specific region to exhibit reduced stiffness and become extendable while maintaining stiffness in another region so that deformation is minimized as temperature varies, and that is further capable of omitting boundary regions to maintain an overall stable structure, as well as enabling control of specific parameters and implementing a simple manufacturing process and simplified circuit wiring.

In addition, exemplary embodiments of the present invention also provide a method for manufacturing the stretchable substrate.

In addition, exemplary embodiments of the present invention also provide a method for varying stiffness distribution of the stretchable substrate.

According to an example embodiment of the present invention, a stretchable substrate includes a stiffness-maintenance portion and a stiffness-variable portion that are partitioned into different regions. In addition, the stretchable substrate maintains a predetermined stiffness when both the stiffness-maintenance portion and the stiffness-variable portion are at or below a predetermined temperature. The stiffness-variable portion may be deformed so as to become stretchable by having a stiffness lower than the predetermined stiffness when the predetermined temperature is exceeded.

In an example embodiment, the stiffness-maintenance portion may be formed such that a plurality of regions may have a predetermined pattern, and the stiffness-variable portion may be formed in other regions excluding the stiffness-maintenance portion.

In an example embodiment, a length of the stiffness-maintenance portion along a first direction and a length of the stiffness-maintenance portion along a second direction perpendicular to the first direction may be different from each other.

In an example embodiment, a device may be mounted on the stiffness-maintenance portion.

In an example embodiment, the stiffness-variable portion may have a predetermined pattern, and the stiffness-maintenance portion may be formed in other regions excluding the stiffness-variable portion.

In an example embodiment, the stiffness-variable portion may be formed along a kirigami pattern.

In an example embodiment, a Poisson's ratio may be negative, and when stretching occurs in the first direction, stretching in the second direction perpendicular to the first direction may occur at the same ratio.

In an example embodiment, the predetermined temperature may be a glass transition temperature of the stiffness-variable portion.

In an example embodiment, the glass transition temperature of the stiffness-variable portion may be lower than the glass transition temperature of the stiffness-maintenance portion.

In an example embodiment, the stiffness-maintenance portion and the stiffness-variable portion include PDMS (polydimethylsiloxane) or polyimide.

According to another example embodiment of the present invention, with respect to a method for manufacturing the stretchable substrate including a stiffness-maintenance portion and a stiffness-variable portion that are partitioned into different regions, the method includes positioning a mask such that an opening thereof is aligned with the stiffness-maintenance portion, and providing ultraviolet light from an upper side of the mask such that only the stiffness-maintenance portion is irradiated with the ultraviolet light.

In an example embodiment, as only the stiffness-maintenance portion is irradiated with the ultraviolet light, the glass transition temperature of the stiffness-variable portion may be formed to be lower than the glass transition temperature of the stiffness-maintenance portion.

In an example embodiment, the stretchable substrate may include a glycol gel.

In an example embodiment, as only the stiffness-maintenance portion is irradiated with the ultraviolet light, the glycol gel forms a network through photochemical crosslinking, and polyimide may be polymerized in spaces between the network so that high-density polymer entanglement is induced.

In an example embodiment, a degree of transmission of the ultraviolet light through the opening of the mask may gradually decrease from a central portion toward a peripheral portion of the opening.

In an example embodiment, the ultraviolet light may be modulated light in which an intensity gradually decreases from a central portion toward a peripheral portion of the opening.

In an example embodiment, the glass transition temperature of the stiffness-maintenance portion may gradually decrease from the central portion toward a peripheral portion that is a boundary with the stiffness-variable portion.

In an example embodiment, the stiffness-maintenance portion may be formed to have a greater thickness than the stiffness-variable portion.

In an example embodiment, a thickness of the stiffness-maintenance portion may gradually decrease from the central portion toward a peripheral portion that is a boundary with the stiffness-variable portion.

According to still another example embodiment of the present invention, with respect to the method for varying the stretchable substrate including a stiffness-maintenance portion and a stiffness-variable portion that are partitioned into different regions, the method includes maintaining a temperature of the stiffness-maintenance portion and heating only the stiffness-variable portion to increase a temperature thereof, or heating the stretchable substrate such that the stiffness-variable portion has a higher temperature than the stiffness-maintenance portion.

In an example embodiment, when only the stiffness-variable portion is heated so as to increase the temperature thereof, a heater may be attached to a lower surface of the stiffness-variable portion.

In an example embodiment, when the stretchable substrate is heated such that the stiffness-variable portion maintains a temperature relatively higher than the stiffness-maintenance portion, the stiffness-variable portion may be formed to have a thermal diffusivity higher than that of the stiffness-maintenance portion.

In an example embodiment, when the stretchable substrate is heated such that the stiffness-variable portion maintains a temperature relatively higher than the stiffness-maintenance portion, the stiffness-variable portion may be formed to include a greater amount of photothermal particles than the stiffness-maintenance portion. According to exemplary embodiments of the present invention,

According to the example embodiments, in a stretchable substrate having a self-regulated stiffness distribution, only the stiffness-variable region becomes lower in stiffness above a predetermined temperature and becomes deformable so as to be stretchable, such that, by controlling the temperature, the stiffness in a specific region is maintained while the stiffness in another region is varied. As a result, it is possible to configure the stretchable substrate to have different stiffness distributions.

In particular, when the stiffness-maintaining region is formed in a specific arrangement and a device is mounted on the stiffness-maintaining region, the stretchable substrate may maintain stretchability while minimizing stretchability in the region where the device is mounted through temperature control. Accordingly, a stable connection state of the device may be maintained. In this case, by forming the stiffness-maintaining region in various patterns or shapes and mounting the device on the stiffness-maintaining region, the stretchable substrate may be configured to have various stiffness distributions.

Furthermore, structural instability or contact issues occurring at the boundary between a conventional stretchable region and a non-stretchable region may be resolved, and the stretchable substrate may maintain stretchability while maintaining structural stability at the boundary through the continuous structural characteristics of the same material.

Moreover, the temperature control may be performed based on information regarding the glass transition temperatures of the stiffness-variable region and the stiffness-maintaining region, and stretchability control of the stretchable substrate having a variable-stiffness structure may be performed within the corresponding glass transition temperature ranges. In this case, based on information regarding the temperature ranges during a manufacturing process of the stretchable substrate or during use, the glass transition temperatures of the stiffness-variable region and the stiffness-maintaining region may be formed differently, such that the stiffness may be maintained at a high level during the manufacturing process to ensure process stability, while the stiffness may be varied during actual use to improve the usability of the stretchable substrate.

As a method for forming different glass transition temperatures of the stiffness-variable region and the stiffness-maintaining region, ultraviolet light may be applied only to the stiffness-maintaining region on the stretchable substrate so that the glass transition temperature is formed to be relatively higher. Accordingly, the stretchable substrate may be manufactured through material selection and a relatively simple process.

In particular, by providing ultraviolet light such that the light intensity gradually changes in the stiffness-maintaining region, or by manufacturing a mask such that the opening degree of the mask gradually changes, the structural stability during repeated stretching of the stretchable substrate may be further improved through a gradual stiffness variation at the boundary between the stiffness-variable region and the stiffness-maintaining region.

Also, by forming the stiffness-maintaining region to have a relatively large thickness, the strain or stretch ratio of the stiffness-maintaining region may be further reduced, such that the strain of a device mounted on the stiffness-maintaining region is minimized, enabling stable device connection and allowing the manufacture of a stretchable substrate with high electrical stability and reliability.

Additionally, by heating the stiffness-maintaining region and the stiffness-variable region at different temperatures or by heating only the stiffness-variable region, the stiffness distribution in the stretchable substrate may be varied. Through this, the regions of the stiffness-maintaining region and the stiffness-variable region may be defined to have various patterns or arrangements. Further, by varying the stiffness distribution through a relatively simple heating method, it is possible to manufacture a stretchable substrate having various characteristics of a self-regulated stiffness distribution.

### BRIEF DESCRIPTION OF THE DRAWINGS

FIG. 1 is a perspective view illustrating a stretchable substrate having a self-regulated stiffness distribution according to an example embodiment of the present invention;
FIG. 2 is a schematic view for explaining a state in which the stiffness distribution is varied in accordance with temperature variation in the stretchable substrate of FIG. 1;
FIG. 3A and FIG. 3B are graphs for explaining a state in which a self-regulated stiffness distribution is implemented according to a distribution of glass transition temperatures in the stretchable substrate of FIG. 1;
FIG. 4 is a perspective view illustrating a stretchable substrate having a self-regulated stiffness distribution according to another example embodiment of the present invention;
FIG. 5 is a perspective view illustrating a stretchable substrate having a self-regulated stiffness distribution according to still another example embodiment of the present invention;
FIG. 6 is a process diagram illustrating a method for manufacturing the stretchable substrate of FIG. 1;
FIG. 7A and FIG. 7B are process diagrams illustrating a method for manufacturing a stretchable substrate according to still another example embodiment of the present invention;
FIGS. 8A to FIG. 8D are process diagrams illustrating a method for manufacturing a stretchable substrate according to still another example embodiment of the present invention;
FIG. 9A and FIG. 9B are process diagrams illustrating a method for varying a stiffness distribution of a stretchable substrate according to still another example embodiment of the present invention; and
FIG. 10A and FIG. 10B are graphs for explaining stress-concentration phenomena occurring in accordance with temperature variation in the stretchable substrate of FIG. 1.

### <Reference numerals>

| | | | |
|---|---|---|---|
| 10, 11, 12, 20, 30, 40: | stretchable substrate | | |
| 20, 21: | base substrate | 22: | recessed portion |
| 50: | ultraviolet light | 150: | protruded portion |
| 100, 101, 102, 104, 105, 106: | stiffness-variable region | | |
| 200, 201, 202, 203, 204, 205: | stiffness-maintaining region | | |
| 211: | central region | 212: | peripheral region |
| 300, 301: | mask | 310: | opening portion |
| 400: | electronic device | | |

### DETAILED DESCRIPTION OF THE INVENTION

The present invention may be modified in various ways and may take different forms, therefore, specific embodiments will be described in detail in the specification. However, the disclosure is not intended to limit the invention to the particular forms described, and it should be understood to include all modifications, equivalents, and alternatives that fall within the spirit and scope of the invention. In the drawings, similar reference numerals designate corresponding elements, and terms such as "first," "second," etc. are merely used to distinguish one element from another, and are not intended to limit the scope of the invention.

The terminology used in the present application is for the purpose of describing particular embodiments only, and is not intended to limit the invention. Unless the context clearly indicates otherwise, the singular forms include the plural.

As used herein, the terms "include" and "consist of" indicate the presence of features, numerals, steps, operations, elements, parts, or combinations thereof described in the specification, but do not preclude the possibility of the presence or addition of one or more other features, numerals, steps, operations, elements, parts, or combinations thereof.

Unless otherwise defined, all terms used herein, including technical and scientific terms, have the same meanings as commonly understood by one of ordinary skill in the art to which the present invention pertains. Terms defined in general dictionaries should be interpreted as having meanings consistent with the contextual meanings in the relevant technical field, and unless specifically defined in the present application, such terms should not be interpreted in an idealized or overly formal sense.

Hereinafter, the present invention will be explained in detail with reference to the drawings.

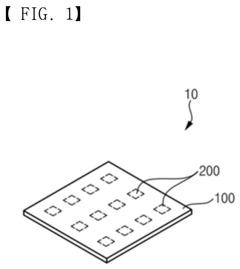

FIG. 1 is a perspective view illustrating a stretchable substrate having a self-regulated stiffness distribution according to an example embodiment of the present invention.

Referring to FIG. 1, a stretchable substrate 10 having a self-regulated stiffness distribution (hereinafter also referred to as "stretchable substrate") according to the present example embodiment is partitioned into a stiffness-variable portion 100 and a stiffness-maintaining portion 200.

The stiffness-variable portion 100 is defined as a region in which stiffness is varied as the temperature is changed to a specific temperature, as will be described below, and the stiffness-maintaining portion 200 is defined as a region in which stiffness is not varied irrespective of the change in temperature to the specific temperature. At this time, a range of temperature variation and a variation in stiffness according thereto will be described later.

The stiffness-variable portion 100 is defined as a region in which the stiffness-maintaining portion 200 is not formed.

In addition, as described above, when the stiffness-variable portion 100 is defined as a specific region, in a region corresponding to the stiffness-variable portion 100, the whole of the stretchable substrate 10 in a thickness direction of the stretchable substrate 10 corresponds to the stiffness-variable portion 100 regardless of the thickness of the stretchable substrate 10. The same applies to the stiffness-maintaining portion 200. That is, the stiffness-variable portion 100 or the stiffness-maintaining portion 200 does not have a property in which stiffness is varied or maintained only at a surface of the stretchable substrate 10, but has a property in which stiffness is varied or maintained over the entirety of the stretchable substrate 10 in the thickness direction.

Of course, as will be described below, the stretchable substrate 10 may also be formed so as to have different stiffnesses along the thickness direction, and this will be described later.

In addition, as illustrated, the stiffness-maintaining portion 200 does not overlap the stiffness-variable portion 100, and each of them is defined as a different region. In this case, the stiffness-maintaining portion 200 may, for example, have a respective predetermined region and, as a whole, may have an m×n matrix arrangement (where m and n are natural numbers).

However, the arrangement state or arrangement pattern of the stiffness-maintaining portion 200 is not limited to the matrix arrangement and may have various arrangements. That is, each of the stiffness-maintaining portions 200 may form a predetermined area while having, in addition to the illustrated rectangular shape, a circular shape or various other shapes, and the arrangement pattern thereof may also have various arrangements and patterns, such as a structure in which the stiffness-maintaining portions are arranged at arbitrary positions, a structure in which a pattern elongated in one direction is repeatedly arranged, or a zigzag structure. Additional arrangements or patterns of the stiffness-maintaining portion 200 will be additionally illustrated and described with reference to drawings described below.

However, each of the stiffness-maintaining portions 200 may have a predetermined area and may be formed so as to be spaced apart from one another in plurality.

As described above, in regions in which the stiffness-maintaining portions 200 are formed, predetermined electronic devices may be mounted. That is, at least one electronic device may be mounted in each region formed by the stiffness-maintaining portions 200. At this time, the type, structure, and function of the electronic device are not limited.

For example, the electronic device may be a micro light emitting device (micro LED). In addition, as described above, when the electronic device is mounted on the stiffness-maintaining portion 200, a wiring structure for driving the electronic device also needs to be formed on the stretchable substrate 10, but an additional illustration of the wiring structure is omitted.

In the case of the wiring structure, a wiring structure already known in the related art may be directly applied, and the wiring structure may be additionally formed on a lower surface of the stretchable substrate 10 or inside the stretchable substrate 10, and its formation structure is not limited. Furthermore, the wiring structure may be formed in a required shape or structure over the entire region of the stretchable substrate 10 without being distinguished between the stiffness-variable portion 100 and the stiffness-maintaining portion 200.

In the present example embodiment, a configuration of the stretchable substrate 10 as a substrate of the stiffness-variable portion 100 and the stiffness-maintaining portion 200 will be described, and, as in the wiring structure described above, components that need to be additionally formed in order for the stretchable substrate 10 to be used as a display device or the like may be directly applied as components according to the related art, and thus a description thereof will be omitted. Likewise, it is apparent that the components to be additionally provided may be disposed on an upper surface, a lower surface, or inside the stretchable substrate 10.

In the stretchable substrate 10, as described above, the stiffness-variable portion 100 and the stiffness-maintaining portion 200 have characteristics in which stiffness is varied or maintained through a change in temperature to the specific temperature, but both may be formed of the same material. That is, with respect to the stretchable substrate 10 formed of the same material, by additionally performing specific treatments or processes as will be described below, characteristics are varied so that the stretchable substrate 10 is partitioned into a region in which stiffness is stably maintained and a region in which stiffness is varied.

Hereinafter, a partitioning of the stiffness-variable portion 100 and the stiffness-maintaining portion 200 and characteristics of the self-regulated stiffness distribution of the stretchable substrate 10 resulting therefrom will be described in more detail.

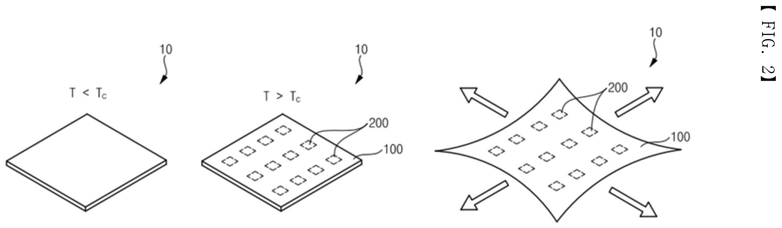

FIG. 2 is a schematic view for explaining a state in which the stiffness distribution is varied in accordance with temperature variation in the stretchable substrate of FIG. 1.

Referring to FIG. 2, when the stretchable substrate 10 is maintained at a temperature lower than a predetermined temperature Tc (T<Tc), the stretchable substrate 10 maintains an overall and uniformly high stiffness. Accordingly, in this state, the stretchable substrate 10 does not exhibit stretchability and maintains a high-stiffness and stable structure.

However, when the stretchable substrate 10 is exposed to an environment higher than the predetermined temperature Tc (T>Tc), the stiffness-maintaining portions 200 retain relatively high stiffness identical to the initial state, whereas the stiffness-variable portions 100 have stiffness lower than that in the initial state.

Therefore, in such a state, the stiffness-maintaining portions 200 do not stretch by external forces and maintain a stable structure, while the stiffness-variable portions 100 are stretched and deformed by external forces. Accordingly, as illustrated, the stretchable substrate 10 can be elongated or compressed in the direction of the external force.

In other words, although the overall length of the stretchable substrate 10 may be elongated or reduced depending on the external force, the stiffness-maintaining portions 200, on which the electronic devices are mounted, retain their initial shape without structural variation.

Therefore, the mounting state and the electrical connection state of the electronic devices in the regions where the electronic devices are mounted can be stably maintained. In this case, wiring structures for driving the electronic devices can also maintain stable electrical connections when they are formed in the regions where the electronic devices are mounted. However, when such wiring structures are formed in the stiffness-variable portions 100, which are regions where no electronic device is mounted, the wiring structures need to be formed of materials capable of deforming together with the stiffness-variable portions 100 in consideration of the degree of deformation thereof.

As described above, the reason why stretchability is not induced in the stiffness-maintaining portions 200 defined as local regions and why these portions maintain a relatively high stiffness and stable structure will be described with reference to the following drawings.

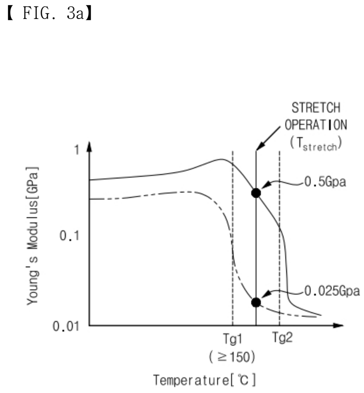

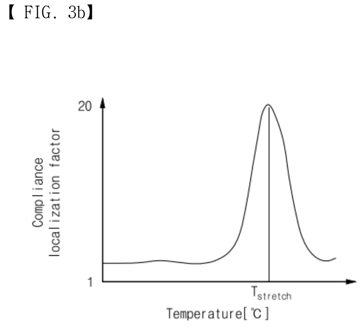

FIG. 3A and FIG. 3B are graphs for explaining a state in which a self-regulated stiffness distribution is implemented according to a distribution of glass transition temperatures in the stretchable substrate of FIG. 1.

Referring first to FIG. 3A, when the stretchable substrate 10 includes a first material and the glass transition temperature of the first material is Tg1, the first material may exhibit a rapid decrease in stiffness at a temperature higher than the glass transition temperature Tgl.

Likewise, when the stretchable substrate 10 includes a second material and the glass transition temperature of the second material is Tg2, the second material may also exhibit a rapid decrease in stiffness at a temperature higher than the glass transition temperature Tg2.

In this case, when the stretchable substrate 10 is maintained within a temperature range between the glass transition temperature Tgl of the first material and the glass transition temperature Tg2 of the second material, the stiffness of the region including the first material may decrease, whereas the stiffness of the region including the second material may not decrease and may remain at a constant level.

As a result, in the stretchable substrate 10, the region including the first material may exhibit reduced stiffness and, as illustrated in FIG. 3B, may possess high stretchability such that it can be easily deformed by an external force, whereas the region including the second material may maintain its stiffness and may not be deformed.

Therefore, by maintaining the stretchable substrate 10 within a temperature range between Tgl and Tg2, the stretchable substrate 10 may be controlled to exhibit stretchability and deformation in response to an external force. In other words, by selecting the first and second materials such that the temperature T of the environment in which the stretchable substrate 10 is used falls within the temperature range between Tgl and Tg2, or by adjusting the glass transition temperatures of the first and second materials such that the temperature T falls within the range between the glass transition temperatures, the stretchable substrate 10 may be controlled such that a specific region is stretchable while another region maintains its stiffness.

As described above, when the stretchable substrate 10 is configured such that different regions have different glass transition temperatures, the stretchable substrate 10 may be controlled such that a specific region exhibits stretchability while another region maintains stiffness.

This control of stretchability applies not only when the stretchable substrate 10 includes different first and second materials, but also when the stretchable substrate 10 includes the same material throughout but is processed such that the respective regions have different glass transition temperatures.

That is, even when the stretchable substrate 10 includes the same material in all regions, if a specific region is processed to have a glass transition temperature different from that of another region, the difference in glass transition temperature between the specific region and the other region may allow the stretchability to be controlled as described with reference to FIGS. 3A and 3B.

In this case, as previously described, when the temperature T of the environment in which the stretchable substrate 10 is used falls within the temperature range between the glass transition temperatures of the specific region and the other region, the stretchable substrate 10 may exhibit different stretchabilities in the respective regions.

Furthermore, by controlling the process temperature T' of the stretchable substrate 10 to be lower than both the glass transition temperature of the specific region and that of the other region, the stretchable substrate 10 may maintain uniform stiffness with minimized stretchability during processing. Likewise, by controlling the process temperature T' to be higher than both glass transition temperatures, the stretchable substrate 10 may exhibit stretchability in all regions and may be deformable during processing.

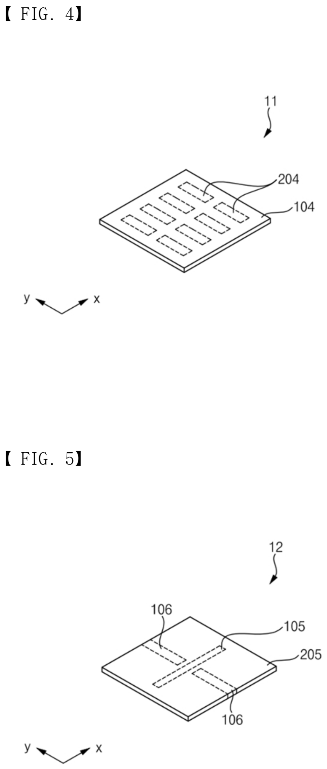

FIG. 4 is a perspective view illustrating a stretchable substrate having a self-regulated stiffness distribution according to another example embodiment of the present invention.

The stretchable substrate 11 according to the present example is substantially identical to the stretchable substrate 10 described with reference to FIG. 1, except for the shape and arrangement of the stiffness-maintaining portions 204, and therefore repeated descriptions will be omitted.

Referring to FIG. 4, in the stretchable substrate 11 according to the present example, the stiffness-maintaining portions 204 are arranged such that a plurality of the stiffness-maintaining portions 204 are disposed in parallel with one another along a first direction X, and are arranged to extend relatively long in a second direction Y perpendicular to the first direction X. In this case, as illustrated, two stiffness-maintaining portions 204 may be continuously arranged along the second direction Y. Of course, a single stiffness-maintaining portion 204 may extend with a relatively long length along the second direction Y, or three or more stiffness-maintaining portions 204 may be continuously arranged.

Accordingly, in the present example, the stiffness-maintaining portion 204 is formed such that its length along the second direction Y is relatively greater than its length (i.e., width) along the first direction X. Thus, in the stretchable substrate 11, the stretchability along the first direction X, where the stiffness-maintaining portions 204 occupy a relatively smaller area, becomes greater than the stretchability along the second direction Y.

As described earlier, the stiffness-maintaining portions 204 have the same characteristics throughout the thickness direction of the stretchable substrate 11, and the stiffness-maintaining characteristics are not limited only to the surface of the stretchable substrate 11. The same applies to the stiffness-variable portions 104.

As described above, since the stiffness-maintaining portions 204 form a relatively long rectangular shape along a specific direction, an electronic device having a relatively long rectangular shape may be mounted more stably. Furthermore, because the stiffness-maintaining portions 204 have different lengths along the first direction X and the second direction Y, the stretchability along the first direction X and the stretchability along the second direction Y become different, so various applications may be realized. An example of such an application is a rollable display.

FIG. 5 is a perspective view illustrating a stretchable substrate having a self-regulated stiffness distribution according to still another example embodiment of the present invention.

The stretchable substrate 12 according to the present example embodiment is substantially identical to the stretchable substrate 10 described with reference to FIG. 1, except for the shapes and arrangements of the stiffness-maintaining portion 205 and the stiffness-variable portions 105 and 106, and therefore, redundant description is omitted.

Referring to FIG. 5, in the stretchable substrate 12 according to the example embodiment, the stiffness-maintaining portion 205 occupies most of the area of the stretchable substrate 12, while the stiffness-variable portions 105 and 106 are formed to extend in specific directions.

That is, the first stiffness-variable portion 105 extends across the stretchable substrate 12 in the first direction X with a predetermined length, and the second stiffness-variable portion 106 extends in the second direction Y and is truncated where it meets the first stiffness-variable portion 105. In this case, although the first stiffness-variable portion 105 does not extend to the side surface of the stretchable substrate 12, the second stiffness-variable portion 106 may extend to the side surface of the stretchable substrate 12.

Thus, the first and second stiffness-variable portions 105 and 106 are formed in the overall shape of a cross (+) on the stiffness-maintaining portion 205, and this corresponds to a configuration in which the cutting-line portion of a so-called kirigami pattern is formed as the stiffness-variable portions 105 and 106. In this case, it is sufficient that the first and second stiffness-variable portions 105 and 106 are formed substantially along the cutting lines of the kirigami pattern, and this does not necessarily mean that cutting is actually performed along the kirigami pattern.

Through this arrangement, unlike FIG. 4, the length of the stiffness-maintaining portion 205 along the first direction X in the stretchable substrate 12 may be substantially identical to the length thereof along the second direction Y.

Meanwhile, with the arrangement of the stiffness-variable portions and the stiffness-maintaining portion as illustrated in FIG. 5, the overall Poisson's ratio of the stretchable substrate 12 becomes negative and approaches -1. Accordingly, when the stretchable substrate 12 is stretched in the second direction Y, stretching in the first direction X occurs at a similar ratio, enabling uniform elongation or uniform contraction over the entire stretchable substrate 12.

Thus, with the stretchable substrate 12 according to the example embodiment, distortion of the aspect ratio of a display image due to uniaxial stretching may be significantly reduced.

Furthermore, in the example embodiment as well, not only the stiffness-variable portions 105 and 106 but also the stiffness-maintaining portion 205 may have the same characteristics throughout the thickness direction of the stretchable substrate 12.

Below, example embodiments relating to a method for forming different glass transition temperatures in different regions of the stretchable substrate 10, which includes the same material but is treated such that specific regions have different glass transition temperatures, will be described.

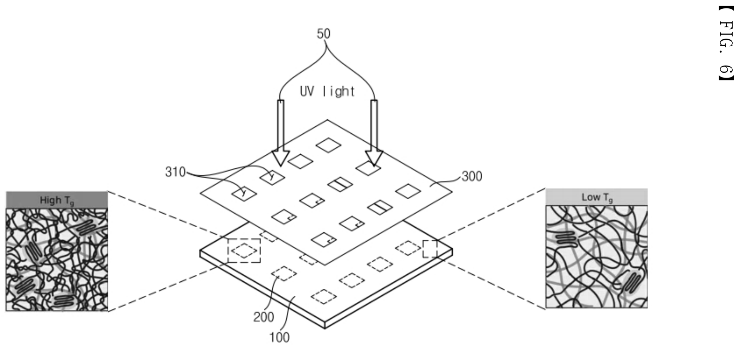

FIG. 6 is a process diagram illustrating a method for manufacturing the stretchable substrate of FIG. 1.

Referring to FIG. 6, in manufacturing the stretchable substrate 10, the mask 300 is aligned on an upper surface of the stretchable substrate 10, which is formed of the same material. The mask 300 blocks ultraviolet (UV) light provided from above and merely needs to include a material capable of blocking UV light.

In addition, as illustrated, the mask 300 includes a plurality of opening portions 310, and the opening portions 310 must be located above positions at which the stiffness-maintaining portions 200 are to be formed in the stretchable substrate 10.

That is, the respective sizes and patterns of the opening portions 310 may be formed substantially identical to the sizes and patterns of the stiffness-maintaining portions 200 to be formed. As previously described, the sizes and patterns of the respective stiffness-maintaining portions 200 may be variably designed in various forms, and the sizes and patterns of the opening portions 310 may simply be designed to match such configurations.

Thereafter, UV light is provided from an upper side of the mask 300, and the UV light passes only through the opening portions 310 and is delivered to the stretchable substrate 10.

Thus, in regions of the stretchable substrate 10 in which the UV light 50 is provided, properties of the material vary according to the UV exposure, and the stiffness-maintaining portions 200 are thereby formed. In other words, only the regions exposed to the UV light 50 become the stiffness-maintaining portions 200, and the regions in which the UV light 50 is blocked remain as the stiffness-variable portions 100.

In this case, the stretchable substrate 10 may include PDMS (polydimethylsiloxane) or polyimide.

In particular, the stretchable substrate 10 may include glycol gel. Accordingly, as shown in FIG. 6, in the region exposed to the UV light 50-namely the stiffness-maintaining portion 200-the glycol gel forms a network by photo-crosslinking, and polyimide is polymerized in spaces between the network, inducing a high-density polymer entanglement.

Specifically, when UV light is irradiated onto the glycol gel, crystalline/entanglement regions of locally high polymer density are formed. Subsequently, when a semi-IPN structure of polyimide is formed in the spaces between the network, a greater degree of polymer entanglement may be induced in the locally high-density region. Accordingly, as illustrated in FIG. 6, the glass transition temperature Tg increases due to the relatively high polymer density.

Meanwhile, in the region irradiated with the UV light, the irradiation intensity or exposure time needs to be controlled to induce sufficient polymer entanglement in the thickness direction, so that uniform properties in the thickness direction may be obtained.

Of course, if only the upper surface region of the stretchable substrate 10-on which the device is mounted-needs to maintain stiffness while the lower side is allowed to vary in stiffness, the UV irradiation intensity or time may be controlled to induce different properties in the thickness direction.

Alternatively, in regions not irradiated with the UV light, locally high polymer-density regions are not formed, and the polymer density remains relatively low, and thus, the glass transition temperature Tg remains relatively low.

Accordingly, in the stretchable substrate 10, the stiffness-maintaining portions 200 exposed to the UV light 50 have a relatively high glass transition temperature Tg2, and the stiffness-variable portions 100 blocked from the UV light 50 have a relatively low glass transition temperature Tgl.

Therefore, as described with reference to FIG. 3, at a temperature Tstretch between the glass transition temperatures (Tg2 - Tg1), the stiffness-maintaining portions 200 retain a relatively high stiffness and do not deform, whereas the stiffness-variable portions 100 decrease in stiffness and stretch or deform under external force.

As described above, even when the stretchable substrate 10 includes the same material, regions with different stiffness characteristics may be formed. This allows certain regions to remain minimally deformable while other regions may stretch and deform.

If an electronic device is mounted on the stiffness-maintaining portion 200-i.e., the region in which deformation is minimized-even when the stiffness-variable portion 100 stretches or deforms under external force, the region on which the electronic device is mounted is minimally deformed, so a stable electrical connection may be maintained. Therefore, the stretchable substrate 10 may maintain electrical and mechanical stability by sustaining a stable connection state of electronic devices mounted therein, even while the substrate itself retains stretchability.

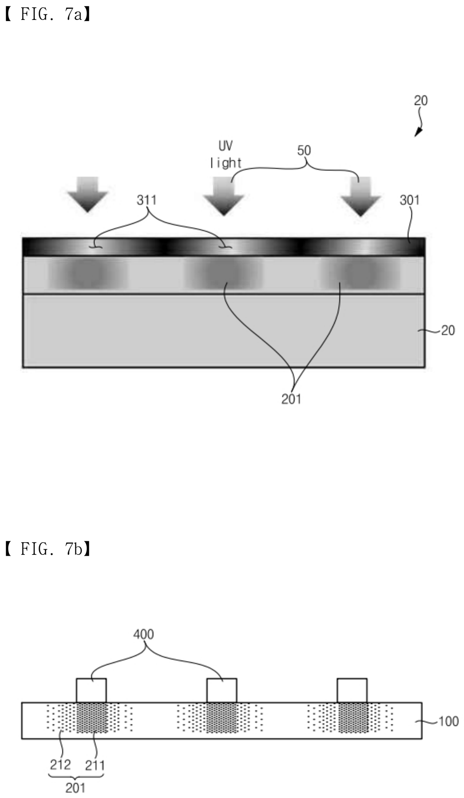

FIG. 7A and FIG. 7B are process diagrams illustrating a method for manufacturing a stretchable substrate according to still another example embodiment of the present invention

In the method for manufacturing the stretchable substrate 20 according to the present example, except for the structural difference of the opening portions 311 formed in the mask 301 and the resulting structural difference of the stiffness-maintaining portions 201, the method is substantially identical to the method described referring to FIG. 6, and therefore repetitive descriptions are omitted.

Referring to FIG. 7A, in the method according to the present example embodiment, the mask 301 is aligned on an upper side of the stretchable substrate 20, which is disposed on the base substrate 20.

The mask 301 blocks ultraviolet (UV) light provided from above and may include any material capable of blocking UV light.

As shown in the figure, the mask 301 includes a plurality of opening portions 311, and the positions where the opening portions 311 are formed must correspond to the upper positions of the stiffness-maintaining portions 201 to be formed on the stretchable substrate 20, as previously described.

In the present example embodiment, the opening portions 311 are formed such that the opening ratio gradually decreases from the central portion toward the peripheral portion, and accordingly, the degree of UV transmission gradually decreases from the central portion toward the peripheral portion. That is, if the UV transmittance of UV light 50 at the central portion is 100%, the UV transmittance gradually decreases toward the peripheral portion and may become 0% at the boundary region between the stiffness-maintaining portion 201 and the stiffness-variable portion 100.

As the UV transmittance through the opening portion 311 gradually decreases from the central portion to the peripheral portion, the degree of UV-induced property variation also decreases accordingly from the central portion to the peripheral portion.

In other words, as explained earlier, due to exposure to UV light 50 supplied through the opening portions 311, the stiffness-maintaining portion 201 exhibits an increase in the glass transition temperature Tg caused by a relatively high polymer density, but the degree of the Tg increase gradually decreases from the central portion 211 toward the peripheral portion 212.

Thus, as shown in FIG. 7B, the stiffness within the stiffness-maintaining portion 201 gradually decreases from the central portion 211 toward the peripheral portion 212, and the stretchability correspondingly increases toward the peripheral portion.

Generally, when the stiffness-maintaining portion 200 and the stiffness-variable portion 100 exhibit a relatively large difference in glass transition temperature as in FIG. 6, an abrupt stiffness difference occurs at the boundary interface between the two portions. This abrupt difference in stretchability or deformation at the boundary interface increases the possibility of damage or defects due to stress concentration in the stretchable substrate 10.

Therefore, in order to minimize such stress concentration caused by abrupt differences in stretchability or deformation at the boundary interface, the present example embodiment gradually decreases the glass transition temperature from the central portion 211 to the peripheral portion 212 within the stiffness-maintaining portion 201, thereby minimizing the difference in stretchability or deformation between the stiffness-maintaining portion 201 and the stiffness-variable portion 100 and mitigating stress concentration.

Accordingly, even when various and repetitive deformations occur in the stretchable substrate 20, damage or defects at the boundary interface may be minimized, and the electrical or mechanical stability of the electronic device 400 mounted on the upper surface of the stiffness-maintaining portion 201 may be further improved.

Meanwhile, instead of forming the opening portions 311 such that the opening ratio gradually decreases as in FIG. 7A, the opening ratio of the opening portions 311 may be maintained constant while the intensity of the irradiated UV light 50 is controlled to gradually decrease from the central portion toward the peripheral portion.

That is, the opening portions 311 may all have 100% transmittance, as in the opening portions 310 of FIG. 6, while the UV light 50 irradiated from above the mask 301 is configured as modulated light whose intensity gradually decreases from the central portion toward the peripheral portion.

By configuring the UV light 50 as modulated light whose intensity gradually decreases from the central portion to the peripheral portion, the intensity of light provided to the stiffness-maintaining portion 201 of the stretchable substrate 20 may become substantially identical to the case in FIG. 7A where the opening ratio of the opening portion 311 is varied.

Thus, as shown in FIG. 7B, in the stiffness-maintaining portion 201, the glass transition temperature Tg gradually decreases from the central portion 211 toward the peripheral portion 212, thereby minimizing the difference in stretchability or deformation at the boundary interface between the stiffness-maintaining portion 201 and the stiffness-variable portion 100 and mitigating stress concentration.

Furthermore, such differences in stretchability or deformation may be induced horizontally across the stretchable substrate 20, or alternatively, may be induced vertically, i.e., in the thickness direction. Therefore, the upper side of the stretchable substrate 20 may be formed to have a relatively high stiffness, while the lower side may be formed to have a relatively low stiffness.

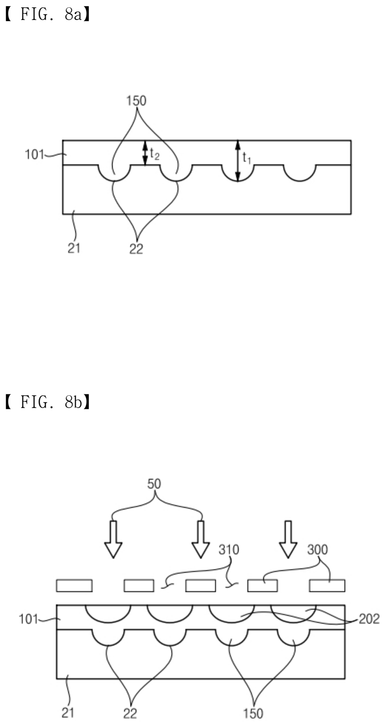

FIGS. 8A to FIG. 8D are process diagrams illustrating a method for manufacturing a stretchable substrate according to still another example embodiment of the present invention.

The method for manufacturing the stretchable substrate 30 according to the present example embodiment is identical to the method described referring to FIG. 6, except that the thicknesses of the stiffness-variable portion 101 and the stiffness-maintaining portion 202 in the stretchable substrate 30 are formed to be different from each other. Accordingly, identical reference numerals are used for identical components, and redundant descriptions will be omitted.

Referring to FIG. 8A, in the stretchable substrate 30 according to the present example embodiment, the stiffness-maintaining portion 202 has a first thickness t1, and the stiffness-variable portion 101 has a second thickness t2. In this case, the first thickness t1 is greater than the second thickness t2.

To implement such a structural feature, the stretchable substrate 30 includes a protruded portion 150 that protrudes downward in the region where the stiffness-maintaining portion 202 is formed. Likewise, in the base substrate 21, which is disposed beneath the stretchable substrate 30 for performing predetermined processes on the stretchable substrate 30, a recessed portion 22 is formed so as to correspond to the protruded portion 150.

In this case, the protruded portion 150 has a curved outer surface and protrudes downward, and may have, for example, a hemispherical shape as illustrated. However, the shape of the protruded portion 150 is not limited thereto, and the protruded portion 150 may be formed such that its thickness gradually decreases from the central region toward the peripheral region.

Accordingly, the first thickness t1 of the stiffness-maintaining portion 202 corresponds to the thickness at the central region of the stiffness-maintaining portion 202, and the first thickness t1 may gradually decrease toward the peripheral region. Thus, the boundary region between the stiffness-maintaining portion 202 and the stiffness-variable portion 101 may have the second thickness t2.

Although not described in detail, the protruded portion 150 may be formed through a transfer process such as imprinting, in which the recessed portion 22 is pre-formed in the base substrate 21, and the stretchable substrate 30 is formed on the upper surface of the base substrate 21. That is, the recessed portion 22 of the base substrate 21 may be directly transferred, thereby forming the protruded portion 150 on the lower surface of the stretchable substrate 30.

As shown in FIG. 8B, for the stretchable substrate 30 including such a protruded portion 150, the mask 300 is positioned above the stretchable substrate 30, and ultraviolet (UV) light 50 is irradiated.

The mask 300 is identical to the mask 300 described with reference to FIG. 6, and includes a plurality of opening portions 310. The opening portions 310 are aligned with the positions and patterns where the stiffness-maintaining portion 202 is to be formed in the stretchable substrate 30.

Accordingly, when the UV light 50 is irradiated, the stiffness-maintaining portion 202 is exposed to the UV light 50 through the opening portions 310, and the glass transition temperature Tg of the stiffness-maintaining portion 202 increases. The internal polymer entanglement behavior leading to the increase of the glass transition temperature is identical to the previously described mechanism.

Thus, as illustrated in FIG. 8B, the stiffness-maintaining portion 202 is formed. However, in the region where the protruded portion 150 is formed, polymer entanglement is not induced internally.

More specifically, because the protruded portion 150 is formed to have a relatively large thickness 11, the irradiated UV light 50 may not reach the lower region of the protruded portion 150 when the intensity of the UV irradiation is controlled. Thus, only the upper portion of the protruded portion 150 is modified by the UV light.

Therefore, in the stretchable substrate 30, the stiffness-maintaining portion 202 is formed only in the upper portion of the protruded portion 150, while the protruded portion 150 does not exhibit an increased glass transition temperature and maintains a glass transition temperature equal to that of the surrounding stiffness-variable portion 101.

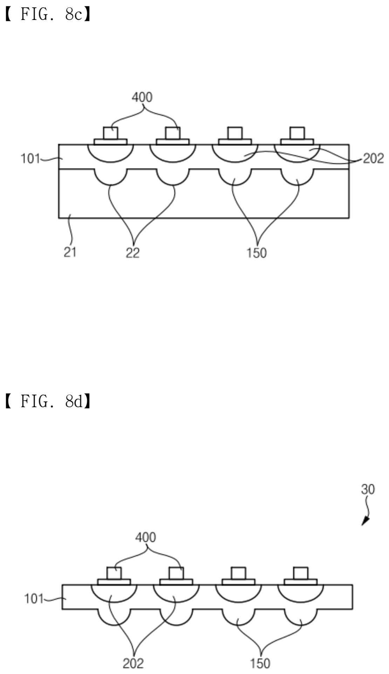

Referring to FIG. 8C and FIG. 8D, after the electronic device 400 is mounted on the upper surface of the stiffness-maintaining region 200, the base substrate 21 positioned underneath is removed to complete the stretchable substrate 30 having the structure shown in FIG. 8D.

In this case, as previously described, the stretchable substrate 30 is formed such that the portion where the electronic device 400 is mounted includes the stiffness-maintaining region 200 having a relatively high glass transition temperature. However, the portions where the electronic device 400 is not mounted remain as the stiffness-variable region 101 having a relatively low glass transition temperature. Furthermore, the protrusion 150 is also a region where ultraviolet light 50 does not reach, and therefore, like the stiffness-variable region 101, it maintains a relatively low glass transition temperature.

Accordingly, only the local portion where the electronic device 400 is mounted retains relatively high stiffness and structural stability, while the remaining regions-including the lower region beneath the electronic device 400-may deform to provide stretchability. That is, while minimizing strain in the region where the electronic device 400 is mounted, the stretchable substrate 30 may stretch and deform across the entire area. Thus, the stretchable substrate 30 may achieve enhanced stretchability while maintaining electrical and mechanical stability of the electronic device 400.

The foregoing describes a method for fabricating a stretchable substrate such that different regions within the substrate have different stiffness values.

However, in addition to fabricating the stretchable substrate so that different regions inherently have different glass transition temperatures, it is also possible to vary stiffness such that different regions exhibit different stretchability even when the stretchable substrate has a uniform glass transition temperature throughout.

Accordingly, a method for varying the stiffness distribution of the stretchable substrate will be described below.

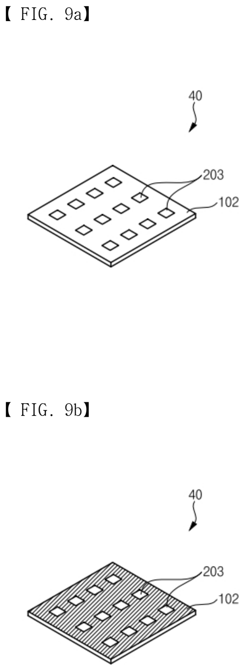

FIG. 9A and FIG. 9B are process diagrams illustrating a method for varying a stiffness distribution of a stretchable substrate according to still another example embodiment of the present invention.

In the stretchable substrate 40 according to the present example embodiment, the fact that the entire substrate includes the same material is identical to the aforementioned stretchable substrates, and furthermore, no ultraviolet irradiation is additionally performed to locally increase the glass transition temperature in specific regions. In other words, the stretchable substrate 40 has the same glass transition temperature Tg across its entire area.

Accordingly, a method for varying the stiffness distribution in the stretchable substrate 40 having a uniform glass transition temperature Tg will be described as follows.

First, referring to FIG. 9A, in the stretchable substrate 40, a stiffness-maintaining region 203 having relatively high stiffness and a stiffness-variable region 102 having relatively low stiffness and being stretchable are defined.

Thereafter, in the stretchable substrate 40, the stiffness-maintaining region 203 and the stiffness-variable region 102 are non-uniformly heated at different temperatures. In this case, the heating temperature of the stiffness-variable region 102 is controlled to be higher than that of the stiffness-maintaining region 203.

As a result, by non-uniformly heating the stiffness-maintaining region 203 and the stiffness-variable region 102 at different temperatures, as shown in FIG. 9B, the stiffness-maintaining region 203 maintains relatively high stiffness, while the stiffness-variable region 102 acquires relatively low stiffness, such that the stiffness-variable region 102 becomes stretchable and deformable.

That is, even when the stretchable substrate 40 has a uniform glass transition temperature Tg throughout its entire area, if a local region is controlled to have a temperature exceeding the glass transition temperature through heating, the stiffness in that region becomes relatively low, enabling stretchable deformation.

Accordingly, the stretchable substrate 40 exhibits a stiffness distribution in which only specific regions become stretchable and deformable.

Meanwhile, an example of non-uniformly heating the stiffness-maintaining region 203 and the stiffness-variable region 102 at different temperatures in the stretchable substrate 40, as shown in FIG. 9A, will be described below.

First, the stiffness-maintaining region 203 may remain unheated, while only the stiffness-variable region 102 is selectively heated to increase its temperature.

To achieve this, a thin-film heater may be attached only to the lower side of the stiffness-variable region 102 so that the temperature of only the stiffness-variable region 102 is increased through heating. In particular, since the stretchable substrate 40 in the present example embodiment includes PDMS (polydimethylsiloxane) or polyimide and therefore exhibits low overall thermal conductivity, even when the stiffness-variable region 102 is locally heated using the thin-film heater, heat transfer to the stiffness-maintaining region 203 is limited.

In such a case, because the stretchable substrate 40 has low thermal conductivity, in order to ensure uniform stiffness variation throughout the thickness direction of the stiffness-variable region 102, thin-film heaters may be attached not only to the lower side but also to the upper side of the stiffness-variable region 102 before heating is performed.

Alternatively, the stretchable substrate 40 may be heated such that the temperature of the stiffness-variable region 102 becomes higher than that of the stiffness-maintaining region 203.

For example, when the stiffness-variable region 102 is formed to have higher thermal diffusivity than the stiffness-maintaining region 203, even when the stretchable substrate 40 is heated overall, the stiffness-variable region 102 may reach a higher temperature. Accordingly, the temperature of the stiffness-variable region 102 may be controlled to be higher than the glass transition temperature, thereby reducing its stiffness and enabling stretchability.

In this case, as an example of overall heating of the stretchable substrate 40, a light source may be disposed around the stretchable substrate 40 to perform heating, although the present invention is not limited thereto.

Furthermore, as another method of heating the stretchable substrate 40 such that the temperature of the stiffness-variable region 102 becomes higher than that of the stiffness-maintaining region 203, the stiffness-variable region 102 may be formed to include a greater amount of photothermal particles than the stiffness-maintaining region 203.

That is, during fabrication of the stretchable substrate 40, particles that induce a photothermal reaction may be mixed into the substrate material, and the distribution or density of the photothermal particles may be made different between the stiffness-maintaining region 203 and the stiffness-variable region 102.

Accordingly, by including photothermal particles in higher distribution or density in the stiffness-variable region 102 than in the stiffness-maintaining region 203, the stiffness-variable region 102 may be heated to a higher temperature even when the stretchable substrate 40 is uniformly heated. As a result, the temperature of the stiffness-variable region 102 may be controlled to exceed the glass transition temperature, enabling its stiffness to be reduced and allowing the region to become stretchable.

In this case, as an example of overall heating of the stretchable substrate 40, a hot plate may be placed under the lower surface of the stretchable substrate 40 to perform heating, although the present invention is not limited thereto.

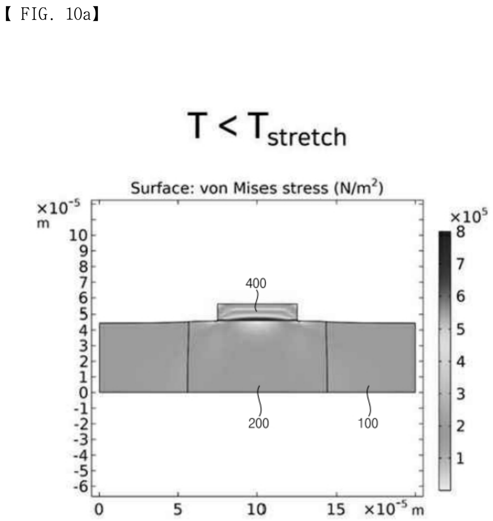

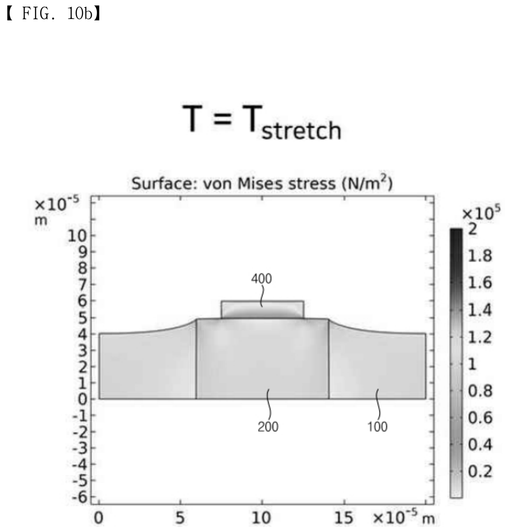

FIG. 10A and FIG. 10B are graphs for explaining stress-concentration phenomena occurring in accordance with temperature variation in the stretchable substrate of FIG. 1.

Referring to FIG. 10A, when the temperature T of the stretchable substrate 10 described in FIG. 1 is maintained lower than the stretch temperature Tstretch illustrated in FIG. 3A (T < Tstretch), the stretchable substrate 10 maintains uniform stiffness throughout the entire substrate. That is, both the stiffness-maintaining region 200 and the stiffness-variable region 100 have the same stiffness.

Accordingly, when an external force is applied to the stretchable substrate 10 under such conditions, the area where the electronic device 400 is mounted experiences stress concentration as the stretchable substrate 10 is elongated, which may lead to defects in the mounting state of the electronic device 400.

Alternatively, referring to FIG. 10B, when the temperature T of the stretchable substrate 10 is maintained equal to the stretch temperature Tstretch illustrated in Fig. 3A (T = Tstretch), the stretchable substrate 10 exhibits locally different stiffness values. That is, because the temperature T is lower than the glass transition temperature Tg2 of the stiffness-maintaining region 200, but higher than the glass transition temperature Tgl of the stiffness-variable region 100, the stiffness-maintaining region 200 maintains relatively high stiffness, while the stiffness-variable region 100 exhibits relatively reduced stiffness.

Accordingly, when an external force is applied to the stretchable substrate 10 under such conditions, the stiffness-maintaining region 200, where the electronic device 400 is mounted, maintains high stiffness and thus undergoes minimal deformation, whereas the stiffness-variable region 100 elongates in response to the tensile force.

Further, during such elongation of the stiffness-variable region 100, no stress concentration occurs in the stiffness-maintaining region 200 where the electronic device 400 is mounted, thereby ensuring that the mounting state of the electronic device 400 remains stable.

Thus, even under repeated stretching caused by repeated external forces, the electronic device 400 maintains a stable mounting state, and both the electrical and mechanical stability of the stretchable substrate 10 may be preserved.

According to the example embodiments, in a stretchable substrate having a self-regulated stiffness distribution, only the stiffness-variable region becomes lower in stiffness above a predetermined temperature and becomes deformable so as to be stretchable, such that, by controlling the temperature, the stiffness in a specific region is maintained while the stiffness in another region is varied. As a result, it is possible to configure the stretchable substrate to have different stiffness distributions.

In particular, when the stiffness-maintaining region is formed in a specific arrangement and a device is mounted on the stiffness-maintaining region, the stretchable substrate may maintain stretchability while minimizing stretchability in the region where the device is mounted through temperature control. Accordingly, a stable connection state of the device may be maintained. In this case, by forming the stiffness-maintaining region in various patterns or shapes and mounting the device on the stiffness-maintaining region, the stretchable substrate may be configured to have various stiffness distributions.

Furthermore, structural instability or contact issues occurring at the boundary between a conventional stretchable region and a non-stretchable region may be resolved, and the stretchable substrate may maintain stretchability while maintaining structural stability at the boundary through the continuous structural characteristics of the same material.

Moreover, the temperature control may be performed based on information regarding the glass transition temperatures of the stiffness-variable region and the stiffness-maintaining region, and stretchability control of the stretchable substrate having a variable-stiffness structure may be performed within the corresponding glass transition temperature ranges. In this case, based on information regarding the temperature ranges during a manufacturing process of the stretchable substrate or during use, the glass transition temperatures of the stiffness-variable region and the stiffness-maintaining region may be formed differently, such that the stiffness may be maintained at a high level during the manufacturing process to ensure process stability, while the stiffness may be varied during actual use to improve the usability of the stretchable substrate.

As a method for forming different glass transition temperatures of the stiffness-variable region and the stiffness-maintaining region, ultraviolet light may be applied only to the stiffness-maintaining region on the stretchable substrate so that the glass transition temperature is formed to be relatively higher. Accordingly, the stretchable substrate may be manufactured through material selection and a relatively simple process.

In particular, by providing ultraviolet light such that the light intensity gradually changes in the stiffness-maintaining region, or by manufacturing a mask such that the opening degree of the mask gradually changes, the structural stability during repeated stretching of the stretchable substrate may be further improved through a gradual stiffness variation at the boundary between the stiffness-variable region and the stiffness-maintaining region.

Also, by forming the stiffness-maintaining region to have a relatively large thickness, the strain or stretch ratio of the stiffness-maintaining region may be further reduced, such that the strain of a device mounted on the stiffness-maintaining region is minimized, enabling stable device connection and allowing the manufacture of a stretchable substrate with high electrical stability and reliability.

Additionally, by heating the stiffness-maintaining region and the stiffness-variable region at different temperatures or by heating only the stiffness-variable region, the stiffness distribution in the stretchable substrate may be varied. Through this, the regions of the stiffness-maintaining region and the stiffness-variable region may be defined to have various patterns or arrangements. Further, by varying the stiffness distribution through a relatively simple heating method, it is possible to manufacture a stretchable substrate having various characteristics of a self-regulated stiffness distribution.

Having described exemplary embodiments of the present invention, it is further noted that it is readily apparent to those of reasonable skill in the art that various modifications may be made without departing from the spirit and scope of the invention which is defined by the metes and bounds of the appended claims.

## Claims

1. A stretchable substrate comprising a stiffness-maintaining region and a stiffness-variable region that are partitioned into different areas,
wherein when a predetermined temperature or lower is applied, the stiffness-maintaining region and the stiffness-variable region maintain a predetermined stiffness, and
wherein the stiffness-variable region is deformed to become stretchable such that stiffness of the stiffness-variable region becomes lower than the predetermined stiffness when a predetermined temperature or higher is applied.

2. The stretchable substrate of claim 1,
wherein the stiffness-maintaining region comprises a plurality of areas formed with a predetermined pattern, and
wherein the stiffness-variable region is formed in an area except for an area of the stiffness-maintaining region.

3. The stretchable substrate of claim 2,
wherein a length of the stiffness-maintaining region along a first direction is different from a length of the stiffness-maintaining region along a second direction perpendicular to the first direction.

4. The stretchable substrate of claim 2,
wherein a device is mounted on the stiffness-maintaining region.

5. The stretchable substrate of claim 1,
wherein the stiffness-variable region comprises a predetermined pattern, and
wherein the stiffness-maintaining region is formed in an area except for an area of the stiffness-variable region.

6. The stretchable substrate of claim 5,
wherein the stiffness-variable region is formed along a kirigami pattern.

7. The stretchable substrate of claim 6,
wherein a Poisson's ratio is negative, and
when stretching occurs in a first direction, stretching in a second direction perpendicular to the first direction occurs at the same ratio.

8. The stretchable substrate of claim 1,
wherein the predetermined temperature is a glass transition temperature of the stiffness-variable region.

9. The stretchable substrate of claim 1,
wherein the glass transition temperature of the stiffness-variable region is lower than a glass transition temperature of the stiffness-maintaining region.

10. The stretchable substrate of claim 1,
wherein the stiffness-maintaining region and the stiffness-variable region comprise polydimethylsiloxane (PDMS) or polyimide.

11. A method for manufacturing a stretchable substrate, the stretchable substrate comprising a stiffness-maintaining region and a stiffness-variable region that are partitioned into different areas, the method comprising:
positioning a mask such that an opening is aligned with the stiffness-maintaining region; and
irradiating ultraviolet light from an upper side of the mask to apply the ultraviolet light only to the stiffness-maintaining region.

12. The method of claim 11,
wherein, due to applying the ultraviolet light only to the stiffness-maintaining region,
a glass transition temperature of the stiffness-maintaining region is formed to be higher than a glass transition temperature of the stiffness-variable region.

13. The method of claim 11,
wherein the stretchable substrate comprises a glycol gel.

14. The method of claim 13,
wherein, due to applying the ultraviolet light only to the stiffness-maintaining region,
the glycol gel forms a network by photo-crosslinking, and polyimide is polymerized in spaces between the networks such that high-density polymer entanglement is induced and the glass transition temperature increases.

15. The method of claim 11,
wherein a degree of ultraviolet transmission gradually decreases from a central portion of the opening toward a peripheral portion.

16. The method of claim 11,
wherein the ultraviolet light is modulated light whose intensity gradually decreases from a central portion of the opening toward a peripheral portion.

17. The method of claim 15 or claim 16,
wherein a glass transition temperature of the stiffness-maintaining region gradually decreases from the central portion toward a boundary portion with the stiffness-variable region.

18. The method of claim 11,
wherein a thickness of the stiffness-maintaining region is formed to be greater than a thickness of the stiffness-variable region.

19. The method of claim 18,
wherein the thickness of the stiffness-maintaining region gradually decreases from a central portion toward a boundary portion with the stiffness-variable region.

20. A method for varying stiffness distribution of a stretchable substrate, the stretchable substrate comprising a stiffness-maintaining region and a stiffness-variable region that are partitioned into different areas, the method comprising:
maintaining a temperature of the stiffness-maintaining region and increasing a temperature by heating only the stiffness-variable region; or
heating the stretchable substrate such that the stiffness-variable region has a higher temperature than the stiffness-maintaining region.

21. The method of claim 20,
wherein, when increasing the temperature by heating only the stiffness-variable region, a heater is attached to a lower surface of the stiffness-variable region.

22. The method of claim 20,
wherein, when heating the stretchable substrate such that the stiffness-variable region has a relatively higher temperature than the stiffness-maintaining region,
the stiffness-variable region is formed to have a higher thermal diffusivity than the stiffness-maintaining region.

23. The method of claim 20,
wherein, when heating the stretchable substrate such that the stiffness-variable region has a relatively higher temperature than the stiffness-maintaining region,
the stiffness-variable region is formed to contain more photothermal particles than the stiffness-maintaining region.
